# EUROPEAN PATENT APPLICATION

(11) **EP 4 715 354 A1**
(43) Date of publication of application: **25.03.2026**
(21) Application number: 25747877.6
(22) Date of filing: 24.01.2025
(51) Int. Cl.: G01K 13/00

(54) **POWER SUPPLY APPARATUS AND TEMPERATURE MEASUREMENT METHOD THEREFOR**

(30) Priority: 31.01.2024 US 202463627094 P
(71) Applicant: Delta Electronics, Inc., Taoyuan City 333 (TW)
(72) Inventor: LIU, Hung-Hsiao, Taoyuan City Taiwan 333 (CN); CHENG, Chang-Yi, Taoyuan City Taiwan 333 (CN); SU, Wei-Te, Taoyuan City Taiwan 333 (CN)
(74) Representative: Nederlandsch Octrooibureau
(86) International application number: PCT/CN2025/074910
(87) International publication number: WO 2025/162309

(57) **Abstract**

A power supply apparatus (100), comprising a bus bar (BUS1), a circuit measurer (120), a temperature sensor (130) and an operation circuit (140). The bus bar (BUS1) is coupled to an inverter (110) and a motor (MOT1). The temperature sensor (130) is configured to measure an initial temperature in an initial state. The circuit measurer (120) is configured to measure a voltage (V1), a current (I1) and an alternating current frequency (F1) on the bus bar (BUS1). The operation circuit (140) is coupled to the circuit measurer (120) and the temperature sensor (130). The operation circuit (140) is configured to solve a resistance value signal (R1) on the basis of the alternating current frequency (F1), solve a first transient power of the bus bar (BUS 1) on the basis of the current (I1) and the resistance value signal (R1) on the bus bar (BUS1), solve a first temperature rise value of the bus bar (BUS1) on the basis of the first transient power; and add the initial temperature to the first temperature rise value so as to obtain a first transient ideal temperature of the bus bar (BUS 1). The present invention further relates to a temperature measurement method (400) for the bus bar (BUS1).

## Description

### BACKGROUND

### Field of Invention

This disclosure relates to a power supply device and a temperature measuring method, and in particular to the power supply device and the temperature measuring method for estimating a transient temperature.

### Description of Related Art

Thermal management systems usually rely on basic thermal models and require manual calibration. Under varying operating conditions, this approach can lead to inefficiencies and possible failures. A temperature measuring device can be configured to measure operating ambient temperature of a circuit device. However, the temperature measuring device is mainly able to measure a steady-state temperature of the circuit device, such as temperature changes every 10 seconds during the continuous operation of the circuit device. The steady-state temperature measurement can only represent an overall operating ambient temperature of the circuit device, and cannot detect a transient temperature of a cable bus in the circuit device at a specific moment (for example, measuring a channel interface temperature of a bus at the moment of operating).

Since temperature measuring devices cannot measure or calculate the transient temperature of a bus inside a circuit in real time, this may make temperature monitoring difficult.

### SUMMARY

The present disclosure provides a power supply device. The power supply device comprises a bus, a temperature sensor, a circuit measuring device and a computing circuit. The bus is coupled an inverter and a motor. The temperature sensor is configured to measure an initial temperature in an initial phase. The circuit measuring device is configured to measure a voltage, a current and an AC frequency on the bus. The computing circuit is coupled to the circuit measuring device and the temperature sensor. The computing circuit is configured to: obtain a resistance value signal based on the AC frequency; obtain a first transient power of the bus based on the current on the bus and the resistance value signal; obtain a first temperature rising value of the bus based on the first transient power; and add the initial temperature and the first temperature rising value to obtain a first transient ideal temperature of the bus.

The present disclosure provides a temperature measuring method for a bus in a power supply device. The power supply device comprises the bus, a circuit measuring device, a temperature sensor and a computing circuit. The bus is coupled to an inverter and a motor. The temperature measuring method comprises: by the temperature sensor, measuring an initial temperature in an initial phase; by the circuit measuring device, measuring a voltage, a current and an AC frequency on the bus; by the computing circuit, obtaining a resistance value signal based on the AC frequency; obtaining a first transient power of the bus based on the current on the bus and the resistance value signal; obtaining a first temperature rising value of the bus based on the first transient power; and adding the initial temperature and the first temperature rising value to obtain a first transient ideal temperature of the bus.

In summary, the power supply device of the present disclosure can just measure the bus voltage, the current and the AC frequency, and then instantly calculate to obtain the transient temperature on the bus in real time.

### BRIEF DESCRIPTION OF THE DRAWINGS

Fig.1 is a schematic diagram of a power supply device according to an embodiment of the present disclosure.
Fig. 2A is a partial schematic diagram of the computing circuit according to the embodiment of Fig.1.
Fig. 2B is a frequency-resistance-value curve diagram according to the embodiment of Fig 2A.
Fig. 3 is a curve diagram related to the embodiment of Fig.2A.
Fig. 4 is a flow chart of a temperature measuring method according to an embodiment of the present disclosure.

The symbols in the figures:
100: power supply device
110: inverter
SW1,SW2,SW3,SW4,SW5,SW6: switch
120: circuit measuring device
130: temperature sensor
140: computing circuit
SC1, SC2: cable
GND: ground terminal
C1, C2, C3, C4, C5, C6: capacitor
CID1, CID2: coupled inductor
MOT1: motor
BUS1: bus
V1: voltage
I1: current
F1: AC frequency
T[0]: initial temperature
T[1]-T[n]: operating ambient temperature
ADC1, ADC2: analog-to-digital converter
DSP1: digital signal processor
AADC1: digital amplifier
FRC2: frequency-to-resistance converter
PD1: power estimating unit
TD1: temperature estimating unit
CMP1: comparing circuit
SIN_ER: control signal
DT[0]: digital initial temperature
DT[1]~DT[n]: digital ambient temperature
D1: digital current value
R1: resistance value signal
TP[1]-TP[n]: transient power
TTI[1]-TTI[n]: transient ideal temperature
400: temperature measuring method
S410, S420, S430, S440, S450, S460: step

### DETAILED DESCRIPTION

The embodiments are described in detail below with reference to the appended drawings to better understand the aspects of the present disclosure. In the figures, the same reference numerals represent the same or similar components or method flows.

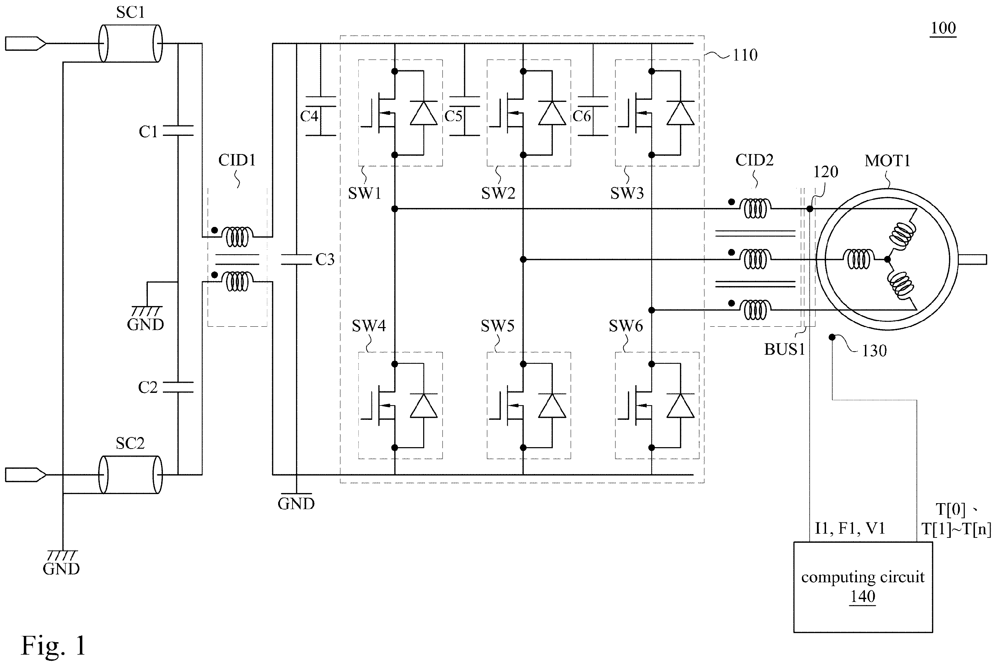

Referring to Fig.1, Fig.1 is a schematic diagram of a power supply device 100 according to an embodiment of the present disclosure. In the embodiment of Fig. 1, the power supply device 100 at least comprises cables SC1, SC2, coupled inductors CID1, CID2, capacitors C1-C6, a motor MOT1, an inverter 110, a circuit measuring device 120, a temperature sensor 130, a bus BUS1 and a computing circuit 140.

In one embodiment, the power supply device 100 can be used in a power supply system of an electric vehicle (as shown in the embodiment of Fig. 1, to power a motor MOT1). However, the present disclosure is not limited thereto. The power supply device 100 can also be used in a renewable energy system (e.g., solar energy or wind energy) or a power supply device based on direct current (e.g., a battery) feeding power to an alternating current grid. In these examples, the load may be replaced by an alternating current grid (not shown) or other similar alternating current power loads instead of the motor MOT1 shown in Fig. 1. The inverter 110 is configured to convert direct current power input (e.g., a battery, a solar panel, a wind turbine) into specific alternating current power output.

In one embodiment, the inverter 110 of the power supply device 100 comprises switches SW1-SW6. The main function of the inverter 110 is to convert the direct current input into the alternating current output of a specific specification.

In one embodiment, the switches SW1-SW6 may be switching elements such as insulated gate bipolar transistors (IGBT) or metal oxide semiconductor field effect transistors (MOSFET). The switches SW1-SW6 switch their switch states according to gate signals to generate three - phase AC power. The switches SW1-SW6 are controlled by precise switching operations to generate waveforms of required frequency and voltage. Three groups of switches SW1-SW6 form a three-phase system, and each group controls the voltage of one phase, thereby forming a balanced three-phase AC power. The output frequency can be adjusted by adjusting the switching speed of switches SW1-SW6 to control the operating frequency of motor MOT1 (i.e., the AC frequency F1 in Figure 1). Precise switch controlling operation can maximize the control of the circuit power consumption, reduce energy loss of power supply device 100 as a whole, and improve the system efficiency.

In one embodiment, the cables SC1 and SC2 can receive input voltage and be coupled to a ground terminal GND. The cable SC1 can also be coupled to a first terminal of the capacitance C1. The first terminal of the capacitance C1 is coupled to the ground terminal GND and a first terminal of the capacitance C2. The cable SC2 can also be coupled to a second terminal of the capacitance C2. In one embodiment, the cables SC1 and SC2 can be shielded cables having surfaces coated with insulating materials.

The first input terminal of the coupled inductor CID1 is coupled to the first terminal of the capacitor C1. The first output terminal of coupled inductor CID1 is coupled to the first terminal of the capacitor C3 and the first terminal of the capacitor C4. The second input terminal of the coupled inductor CID1 is coupled to the second terminal of the capacitor C2. The second output terminal of the coupled inductor CID1 is coupled to the second terminal of the capacitor C3 and the ground terminal GND. The second terminal of the capacitor C4 is coupled to the ground terminal GND.

As shown in Fig. 1, the capacitance C5 and the capacitance C6 may also be disposed in the inverter 110. The first terminal of the switch SW1 is coupled to the capacitance C4, the capacitance C5, the first terminal of the switch SW2, the capacitance C6, and the first terminal of the switch SW3. The second terminal of the switch SW1 is coupled to the first terminal of the switch SW4. The second terminal of the switch SW2 is coupled to the first terminal of the switch SW5. The second terminal of the switch SW3 is coupled to the first terminal of the switch SW6. The second terminal of the switch SW4, the second terminal of the switch SW5, and the second terminal of the switch SW6 are all coupled to the ground terminal GND.

The inverter 110 is coupled to the input terminal of the coupled inductor CID2. The three-phase input terminal of the motor MOT1 can be connected to the output terminal of the coupled inductor CID2 through the bus BUS1.

The measuring terminal of the circuit measuring device 120 can be set on one of the cables of the bus BUS1, for example, connected to one of the three-phase input terminals of motor MOT1 to measure the voltage V1 and the current I1 flowing through the bus BUS1. The circuit measuring device 120 can have a frequency measurement function. Since the input terminal of the motor MOT1 receives the alternating current, the circuit measuring device 120 can measure the AC frequency F1 while measuring the voltage V1 and the current I1. In one embodiment, the measuring terminal of the circuit measuring device 120 can also be set on multiple cables of the bus BUS1. The current I1 of this embodiment can represent the multi-phase current on the multiple cables.

The measuring terminal of the temperature sensor 130 can be set on the circuit board of the power supply device 100, that is, the circuit board set on the surface of the bus BUS 1. For example, the measuring terminal can be set at an arbitrary location near the bus BUS1, as shown in Fig. 1. The present disclosure does not limit the specific location of the measuring terminal of the temperature sensor 130 in the power supply device 100. The temperature sensor 130 can be configured to measure an initial temperature T[0] of its location at the moment of starting operation (also called "initial phase") and the operating ambient temperatures T[1]-T[n] after the bus BUS1 has been operating for a period of time. Here, the "n" can be any positive integer greater than 1, representing the amount of times the temperature sensor 130 measures the bus BUS1 during the operation of the bus BUS1, and it can also represent the amount of operating ambient temperatures measured by the temperature sensor 130 near the bus BUS1.

The computing circuit 140 is coupled to the circuit measuring device 120 and the temperature sensor 130. The computing circuit 140 can receive the voltage V1, the current I1, and the AC frequency F1 through the circuit measuring device 120, and the computing circuit 140 can receive the initial temperature T[0] and the operating ambient temperatures T[1]-T[n] through the temperature sensor 130.

In one embodiment, the computing circuit 140 of the present disclosure controls and protects the bus BUS1 from over-temperature by monitoring and estimating the transient temperature of the bus BUS1, and the over-temperature protecting method is to adjust the voltage V1, the current I1 and the AC frequency F1 through the switches SW1~SW6. The following embodiments will explain in detail how the computing circuit 140 monitors and estimates the transient temperature and specific operations for the subsequent over-temperature protection.

In the initial phase, the computing circuit 140 may receive the initial temperature T[0] through the temperature sensor 130, and calculate the transient power TP[1] based on the initial temperature T[0], the current I1 and the AC frequency F1 measured by the circuit measuring device 120. After obtaining the transient power TP[1], the computing circuit 140 further obtains a first temperature rising value corresponding to the transient power TP[1]. Then, the computing circuit 140 may add the first temperature rising value and the initial temperature T[0] to obtain the transient ideal temperature TTI[1] of the bus BUS1.

After the initial phase, the power supply device 100 may continue to operate, and the temperature in the bus BUS1 may increase over time, thereby causing the thermal resistance of the bus BUS1 to change as the temperature increases. When the power supply device 100 is operating, the computing circuit 140 can first receive the initial temperature T[0] through the temperature sensor 130, obtain the transient ideal temperature TTI[1], and then calculate to obtain the transient power TP[2] of the bus BUS1 based on the transient ideal temperature TTI[1], the current I1 and the AC frequency F1 measured in real time by the circuit measuring device 120. After obtaining the transient power TP[2], the computing circuit 140 can calculate the second temperature rising value of the bus BUS1 based on the transient power TP[2]. And then, the computing circuit 140 can add the second temperature rising value and the initial temperature T[0] to obtain the transient ideal temperature TTI[2] of the bus BUS1.

The computing circuit 140 can continuously calculate to obtain a transient ideal temperature TTI[3] according to the current I1, the AC frequency F1 and the transient ideal temperature TTI[2]. The computing circuit 140 can continuously iterate according to the operation mentioned above, and calculate the temperature value of the bus BUS1 at a certain time point based on the current I1 and the AC frequency F1 of the bus BUS1 at that time point.

In summary, the power supply device 100 can instantly calculate to obtain the transient temperature of bus BUS1 by measuring the current I1 and the AC frequency F1 of bus BUS1.

In addition to the above functions, in the embodiment of Fig. 1, the computing circuit 140 of the power supply device 100 can further compare the transient ideal temperature of the bus BUS1 with the operating ambient temperature measured by the temperature sensor at a certain time point after the power supply device 100 operates from the initial phase to the time point, and then determine whether the bus BUS1 is abnormal.

When the computing circuit 140 determines that the bus BUS1 is abnormal (e.g., the transient temperature is too high, and the service life of the power supply device 100 is insufficient), the computing circuit 140 can quickly cut off power supply of the motor MOT1 by shutting down the switches SW1-SW6 so that current may no longer flow through the bus BUS1. Therefore, the system may be avoided from damage caused by overload or malfunction. The coordinated operation of the switches SW1~SW6 can ensure that power supply device 100 can operate stably and efficiently.

In addition, the computing circuit 140 may be provided a transfer function. The transfer function is set according to location of the measuring terminal of the temperature sensor 130 in the bus BUS1 and the thermal conductivity of the conductive medium (e.g., copper wire, heat pipe or heat conductive metal sheet, etc.) at the measuring terminal of the temperature sensor 130. The computing circuit 140 may convert the overall operating ambient temperature into the bus operating temperature of the bus BUS1 according to the transfer function. In other words, the computing circuit 140 may estimate the bus operating temperature of the bus BUS1 according to the transfer function and the operating ambient temperature. The computing circuit 140 may compare the bus operating temperature of the bus BUS1 with the transient ideal temperature, and then determine whether the bus BUS1 is abnormal at that time point.

When the difference value between the bus operating temperature and the transient ideal temperature is greater than a first threshold, it means that the bus BUS1 has deteriorated, resulting in a larger thermal resistance. In this case, the computing circuit 140 can send a control signal to the gate terminals of the switches SW1-SW6 to control the operation of the switches SW1-SW6. Through the above operation, the computing circuit 140 can reduce the current I1 flowing through the bus BUS1 or reduce the current frequency, thereby allowing the power supply device 100 to be in a load reduction mode to extend the service life of the power supply device 100.

When the difference value between the bus operating temperature and the transient ideal temperature is greater than a second threshold, it means that the bus BUS1 has been over-deteriorated. If no action is taken, the entire power supply device 100 may occur malfunction. In this embodiment, the second threshold is higher than the first threshold. In this case, the computing circuit 140 should send the control signal to the gate of the switches SW1-SW6, so that the switches SW1-SW6 in the overall inverter 110 stops transmitting current to the motor MOT1. In some embodiments, when the computing circuit 140 detects this phenomenon, it can generate and send a warning message (such as a description text, a pattern, an alarm sound) to a display, a speaker or other output interface to inform the user or maintenance personnel of the current deteriorated condition of the bus BUS1, so that the user or maintenance personnel can perform targeted repairs or maintenance.

In the embodiment mentioned above, when the difference value between the bus operating temperature and the transient ideal temperature becomes greater, it means that the cables in the bus BUS1 may be deteriorated or have insufficient service life. For example, the "rainflow counting algorithm" may be executed to estimate the service life of the bus BUS1 according to a deviation of the operating temperature of bus BUS1. When it is determined that the service life of the bus BUS1 is insufficient, the maintenance personnel may be prompted to replace it.

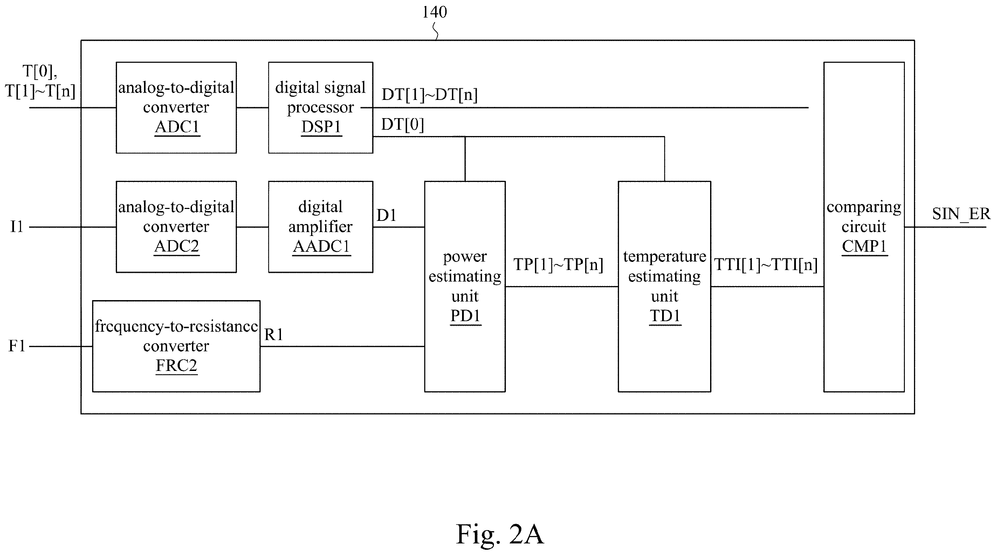

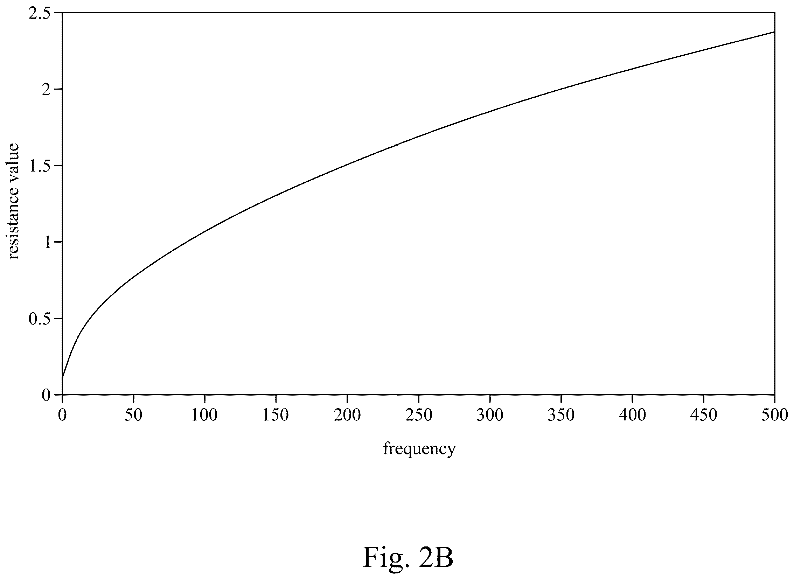

Referring to Figs. 2A and 2B, Fig. 2A is a partial schematic diagram of the computing circuit 140 according to the embodiment of Fig.1, Fig. 2B is a frequency-resistance-value curve diagram according to the embodiment of Fig 2A. The computing circuit 140 may comprise an analog-to-digital converter ADC1, an analog-to-digital converter ADC2, a digital signal processor DSP1, a digital amplifier AADC1, a frequency-to-resistance converter FRC2, a power estimating unit PD1, a temperature estimating unit TD1 and a comparing circuit CMP1.

In the embodiment of Fig. 2A, an input terminal of the analog-to-digital converter ADC1 can sequentially receive the initial temperature T[0] and the operating ambient temperatures T[1]-T[n] through the temperature sensor 130, and an output terminal of the analog-to-digital converter ADC1 can be coupled to the digital signal processor DSP1. The initial temperature T[0] and the operating ambient temperatures T[1]-T[n] are all analog signals. Through the analog-to-digital converter ADC1 and the digital signal processor DSP1, the initial temperature T[0] and the operating ambient temperatures T[1]-T[n] can be converted into the digital initial temperature DT[0] and the digital ambient temperatures DT[1]-DT[n], and the digital initial temperature DT[0] and the digital ambient temperatures DT[1]-DT[n] are all digital signals.

An input terminal of the analog-to-digital converter ADC2 can receive the current I1 through the circuit measuring device 120. An output terminal of the analog-to-digital converter ADC2 can be coupled to the digital amplifier AADC1. The current I1 is an analog signal. Through the analog-to-digital converter ADC2 and the digital amplifier AADC1, the current I1 can be converted into a digital current value D1, and the digital current value D1 is a digital signal.

An input terminal of the frequency-to-resistance converter FRC2 can receive the AC frequency F1 through the circuit measuring device 120. The frequency-to-resistance converter FRC2 has a function of determining the resistance value according to the frequency, and the function can be implied as the frequency-resistance-value curve of Fig. 2B. The frequency-to-resistance converter FRC2 can output a resistance value signal R1 based on the AC frequency F1.

The power estimating unit PD1 can receive the digital initial temperature DT[0], the digital current value D1 and the resistance value signal R1. The power estimating unit PD1 can calculate to obtain the transient power TP[1] based on the above values. After obtaining the transient power TP[1], the power estimating unit PD1 can continue to calculate the transient power TP[1] based on the transient power TP[1], the digital current value D1 and the resistance value signal R1, and so on. The power estimating unit PD1 can calculate to obtain the transient powers TP[1]-TP[n] in sequence.

The temperature estimating unit TD1 is coupled to the power estimating unit PD1 and the digital signal processor DSP1. The temperature estimating unit TD1 can receive the transient powers TP[1]-TP[n] from the power estimating unit PD1, and receive the digital initial temperature DT[0] from the digital signal processor DSP1.

Based on transient powers TP[1]-TP[n], the temperature estimating unit TD1 can correspondingly obtain temperature rising values of the bus with amount "n". The temperature estimating unit TD1 can sequentially add temperature rising values with amount "n" and the digital initial temperature DT[0] to obtain the transient ideal temperatures TTI[1]-TTI[n].

The comparing circuit CMP1 can sequentially receive the digital ambient temperatures DT[1]-DT[n] from the digital signal processor DSP1 and sequentially receive the transient ideal temperatures TTI[1]-TTI[n] from the temperature estimating unit TD1. The comparing circuit CMP1 can convert the digital ambient temperatures DT[1]-DT[n] into the bus operating temperature of the bus BUS1 according to the transfer function mentioned above. The comparing circuit CMP1 can sequentially compare the bus operating temperature corresponding to the digital ambient temperatures DT[1]-DT[n] and the transient ideal temperature TTI[1]-TTI[n], and the comparing circuit CMP1 may output the control signal SIN_ER according to the comparison result of the two.

For example, when the comparing circuit CMP1 receives the digital ambient temperature DT[1] and the transient ideal temperature TTI[1], the digital ambient temperature DT[1] can be converted into a corresponding bus operating temperature. When the difference value between the bus operating temperature and the transient ideal temperature TTI[1] is greater than the first threshold, the comparing circuit CMP1 can send the control signal SIN_ER to the switches SW1-SW6 to control the operation of the switches SW1~SW6. In this way, the computing circuit 140 can reduce the current I1 input to the motor MOT1. When the difference value between the bus operating temperature and the transient ideal temperature TTI[1] is greater than the second threshold, the comparing circuit CMP1 can send the control signal SIN_ER to the switches SW1-SW6 to make the switches SW1~SW6 of the inverter 110 stop transmitting current to the motor MOT1.

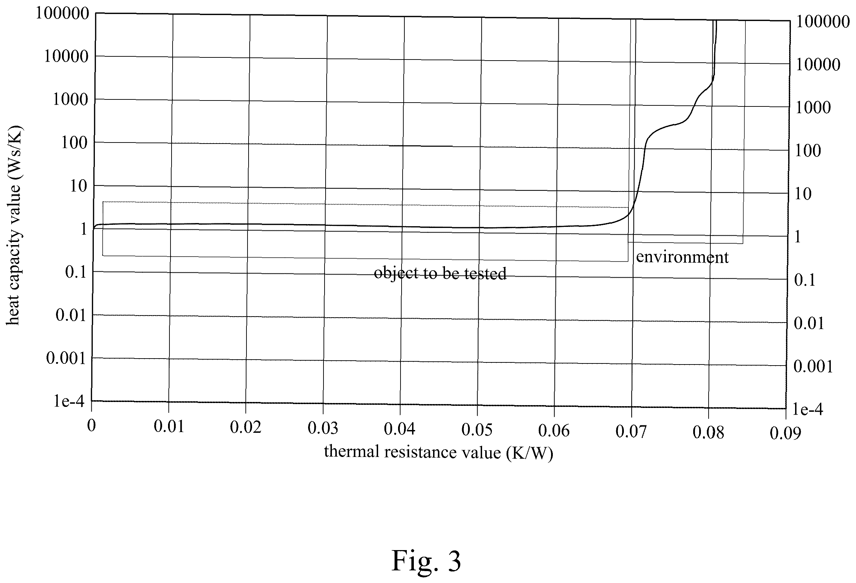

Referring to Fig. 3, Fig. 3 is a curve diagram related to the embodiment of Fig.2A. The curve diagram of Fig. 3 comprises a measurement curve, which can represent the corresponding relationship between the equivalent thermal resistance value of the bus BUS1 (including the circuit board on the surface) and the equivalent heat capacity value on the bus BUS1 (including the circuit board on the surface). The measurement curve mentioned above has the value measured by the change of the thermal resistance value of bus BUS1 over time, and the value measured by the change of the heat capacity value of the bus BUS1 over time is integrated to obtain the curve diagram.

In Fig. 3, the measurement curve is the measurement data pre-stored in a memory device built in the computing circuit 140, and the measurement curve is obtained by measuring the thermal resistance value and heat capacity value of an object to be tested (i.e., the bus BUS1 and the surface of a circuit board for disposing the bus BUS1) which used by the power supply device 100 and the ambient environment of the operating device. Through Fig. 3, the temperature of the bus BUS1 can be estimated by measuring the temperature of the circuit board for disposing the bus BUS1. Fig. 3 is a curve generated by measuring the temperature change in a short period of time, so it is possible to obtain the transient response (transient change) of the object to be tested with the temperature change, so the estimation for the temperature of the bus in the present disclosure can be more accurate. In addition, since the measurement curve of the present disclosure is obtained through the transient change of the multi-layer structure (the bus BUS1 and the circuit board for disposing the bus BUS1), it is possible to determine whether the bus or only the circuit board temperature has temperature that is too high by measuring the surface temperature of the circuit board.

In one embodiment, the user of the present disclosure can construct a using environment equivalent to the power supply device 100 in a laboratory environment, and measure multiple AC frequencies and resistance values of the bus BUS1 under the condition of controlling the ambient temperatures and the fixed conduction currents, and then estimate power loss of the bus BUS1 based on the conduction currents, resistance values and AC frequencies. In some embodiments, the relationship between the power loss and the ambient temperature can be recorded as a comparison table.

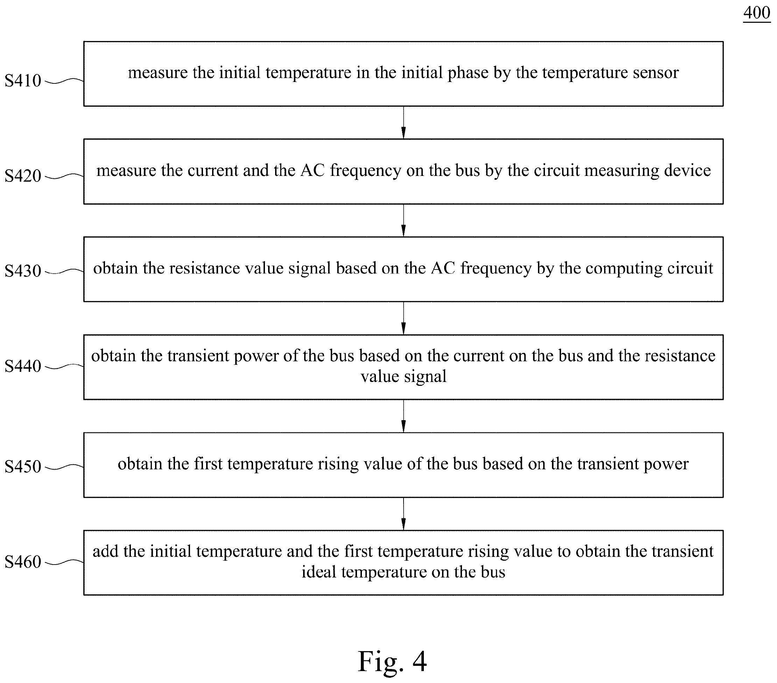

Referring to Fig. 4, Fig. 4 is a flow chart of a temperature measuring method 400 according to an embodiment of the present disclosure. The temperature measuring method 400 is configured to measure and estimate the transient ideal temperature of the bus BUS1 of the power supply device 100.

In step S410, the power supply device 100 may measure the initial temperature T[0] in the initial phase by the temperature sensor 130.

In step S420, the power supply device 100 may measure the current I1 and the AC frequency F1 on the bus BUS1 by the circuit measuring device 120.

In step S430, the power supply device 100 may obtain the resistance value signal R1 based on the AC frequency F1 by the computing circuit 140.

In step S440, the power supply device 100 may obtain the transient power TP[1] of the bus BUS1 based on the current I1 on the bus BUS1 and the resistance value signal R1.

In step S450, the power supply device 100 may obtain the first temperature rising value of the bus BUS1 based on the transient power TP[1].

In step S460, the power supply device 100 may add the initial temperature T[0] and the first temperature rising value to obtain the transient ideal temperature TTI[1] on the bus BUS1.

After step S460, the power supply device 100 may have the transient ideal temperature TTI[1] and continuously calculate to obtain the transient ideal temperatures TTI[2]-TTI[n] according to the temperature measuring method 400.

In summary, the power supply device 100 of the present disclosure can instantly calculate to obtain the transient temperature of bus BUS1 by measuring the current I1 and the AC frequency F1 on bus BUS1. In addition, in some circumstances, the power supply device 100 of the present disclosure can also determine whether the cables of the bus BUS1 in the power supply device 100 have deteriorated by comparing the transient ideal temperature with the ambient temperature when the system is operating.

The above are only preferred embodiments of the present disclosure. Various modifications and variations can be made to the structure of the present disclosure without departing from the scope or spirit of the invention. In view of the foregoing, it is intended that the present invention cover modifications and variations of this invention provided they fall within the scope of the following claims.

## Claims

1. A power supply device, comprising:
a bus, coupled an inverter and a motor;
a temperature sensor, configured to measure an initial temperature in an initial phase;
a circuit measuring device, configured to measure a voltage, a current and an AC frequency on the bus; and
a computing circuit, coupled to the circuit measuring device and the temperature sensor, and the computing circuit is configured to:
obtain a resistance value signal based on the AC frequency;
obtain a first transient power of the bus based on the current on the bus and the resistance value signal;
obtain a first temperature rising value of the bus based on the first transient power; and
add the initial temperature and the first temperature rising value to obtain a first transient ideal temperature of the bus.

2. The power supply device of claim 1, wherein the computing circuit is further configured to:
obtain a second transient power of the bus based on the first transient ideal temperature, the current and the AC frequency when the power supply device is operating;
obtain a second temperature rising value of the bus based on the second transient power; and
add the initial temperature and the second temperature rising value to obtain a second transient ideal temperature of the bus.

3. The power supply device of claim 1, wherein the computing circuit is further configured to:
measure an operating ambient temperature by the temperature sensor when the power supply device is operating;
estimate a bus operating temperature of the bus based on the operating ambient temperature and a transfer function between the bus and the temperature sensor; and
compare the bus operating temperature with the first transient ideal temperature to determine whether the bus is abnormal.

4. The power supply device of claim 3, wherein,
in response to a difference value between the bus operating temperature and the first transient ideal temperature being higher than a first threshold, the computing circuit sends a control signal to reduce the current flowing through the bus; and
in response to the difference value between the bus operating temperature and the first transient ideal temperature being higher than a second threshold, the computing circuit sends the control signal to stop the bus from operating, and the second threshold is higher than the first threshold.

5. The power supply device of claim 1, wherein the computing circuit estimates a motor power loss and a total power of the motor based on the initial temperature, the current on the bus, and the AC frequency, and obtains the first transient power of the bus based on the motor power loss and the total power.

6. A temperature measuring method for a bus in a power supply device, the power supply device comprises the bus, a circuit measuring device, a temperature sensor and a computing circuit, wherein the bus is coupled an inverter and a motor, the temperature measuring method comprises:
by the temperature sensor, measuring an initial temperature in an initial phase;
by the circuit measuring device, measuring a voltage, a current and an AC frequency on the bus;
by the computing circuit, obtaining a resistance value signal based on the AC frequency;
obtaining a first transient power of the bus based on the current on the bus and the resistance value signal;
obtaining a first temperature rising value of the bus based on the first transient power; and
adding the initial temperature and the first temperature rising value to obtain a first transient ideal temperature of the bus.

7. The temperature measuring method of claim 6, further comprising:
obtaining a second transient power of the bus based on the first transient ideal temperature, the current and the AC frequency when the power supply device is operating;
obtaining a second temperature rising value of the bus based on the second transient power; and
adding the initial temperature and the second temperature rising value to obtain a second transient ideal temperature of the bus.

8. The temperature measuring method of claim 6, further comprising:
measuring an operating ambient temperature by the temperature sensor when the power supply device is operating;
estimating a bus operating temperature of the bus based on the operating ambient temperature and a transfer function between the bus and the temperature sensor; and
comparing the bus operating temperature with the first transient ideal temperature to determine whether the bus is abnormal.

9. The temperature measuring method of claim 8, further comprising:
in response to a difference value between the bus operating temperature and the first transient ideal temperature being higher than a first threshold, sending a control signal to reduce the current flowing through the bus; and
in response to the difference value between the bus operating temperature and the first transient ideal temperature being higher than a second threshold, sending the control signal to stop the bus from operating, and the second threshold is higher than the first threshold.

10. The temperature measuring method of claim 6, wherein step of obtaining the first transient power of the bus comprises:
estimating a motor power loss and a total power of the motor based on the initial temperature, the current on the bus, and the AC frequency, and obtaining the first transient power of the bus based on the motor power loss and the total power.
